# NEUE EUROPÄISCHE PATENTSCHRIFT

(11) **EP 0 602 507 B2**
(45) Veröffentlichungstag und Bekanntmachung des Hinweises auf die Entscheidung über den Einspruch: **30.03.2005**
(45) Hinweis auf die Patenterteilung: 15.03.2000
(21) Anmeldenummer: 93119712.3
(22) Anmeldetag: 07.12.1993
(51) Int. Cl.: C04B 35/00, H01L 39/24

(54) **Verfahren zur Erhöhung der Pinning-Kraft von supraleitenden Bi-Sr-Ca-Cu-O Keramik-Formkörpern**
Process for the enhancement of the Pinning force of superconducting bismuth-strontium-calcium-copper-oxygen ceramic bodies
Procédé pour l'augmentation de la force de Pinning de corps formés supraconducteurs type bismuth-strontium-calcium-cuivre-oxygène

(30) Priorität: 12.12.1992 DE 4241998
(43) Veröffentlichungstag der Anmeldung: 22.06.1994
(73) Patentinhaber: Aventis Research & Technologies GmbH & Co. KG, 65926 Frankfurt am Main (DE)
(72) Erfinder: Hettich, Bernhard, Dr., D-65817 Eppstein/Ts. (DE); Elschner, Steffen, Dr., D-65527 Niedernhausen (DE); Majewski, Peter, Dr., D-73635 Rudersberg (DE); Petzow, Günter, Prof. Dr., D-70771 Leinfelden-Echterdingen (DE); Aldinger, Fritz, Prof., D-70569 Stuttgart (DE)
(74) Vertreter: Feray, Valérie

(56) Entgegenhaltungen:
- EP-A- 0 390 499
- EP-A- 0 482 221
- EP-A- 0 592 797
- WO-A-90/04568
- US-A- 5 114 909
- Jap. J. Appl.Phys. Vol. 31; Seiten L163-L165
- Advances in Superconductivity V, Proceedings on 16-19.11.1992 Seiten 741-744
- Advanced Materials 1992, 4, No. 7/8, Seiten 508-511

## Beschreibung

Die technische Anwendung keramischer Bi-Sr-Ca-Cu-O Supraleiter, z.B. in Form von Stäben oder Drähten mit Multifilament-Struktur, ist zur Zeit noch stark eingeschränkt, weil die Hochtemperatur-Supraleiter bei 77 K in einem angelegten Magnetfeld bis jetzt nur geringe elektrische Ströme transportieren können. Dieser Effekt ist auf die Flußsprünge und das Flußkriechen der sogenannten magnetischen Flußschläuche in diesen Materialien zurückzuführen. Für eine technische Anwendung supraleitender Keramiken in einem Magnetfeld ist es daher notwendig, das Flußspringen und -kriechen durch geeignete Stabilisierungsmaßnahmen (Pinning) weitgehend einzuschränken bzw. ganz zu verhindern. Eine Erhöhung der kritischen Stromdichten im Magnetfeld um ein Vielfaches kann durch das Einbringen von Pinning-Zentren in keramischen Supraleitern erreicht werden. Gezielt eingebaute Defekte wie z.B. normalleitende Cluster, Ausscheidungen und Sekundärphasen-Präzipitate in dem supraleitenden Material stellen geeignete Pinning-Zentren dar.

Im Anwendungsfall wird ein solcher Supraleiter bei der Temperatur T < T_{c} und einem äußeren Magnetfeld H_{c1} < Hₐ< H_{c2} betrieben. Prinzipiell liegt in diesem Zustand ein Material vor, in dem zwei physikalische Zustände existieren, nämlich einerseits die supraleitende Matrix, die den Suprastrom trägt, und andererseits normalleitende Bereiche, durch die die magnetischen Feldlinien des äußeren Magnetfeldes verlaufen. Die supraleitende Matrix ist durchsetzt von diesen normalleitenden Bereichen, deren Anzahl mit der magnetischen Feldstärke zunimmt. Die normalleitenden Bereiche werden infolge der klassischen Lorenzkraft (Iₛᵤₚᵣₐ * H_{außen} = F_{lorenz}) durch die supraleitende Matrix bewegt. Diese Bewegung verbraucht Energie, welche dem Suprastrom entzogen wird. Die sogenannten Pinning-Zentren stellen energetische Potentialsenken für diese sich bewegenden "Flußschlauche" dar. Die Höhe der Potentialsenken hängt von ihrer Natur, aber auch Von der Betriebstemperatur des Supraleiters und der Feldstärke des Magnetfeldes ab.

US-A-5,114,909 beschreibt ein aufwendiges Verfahren zur Bildung einer supraleitenden Oxidkeramik mit Pinning-Ausscheidungen. Ein erster Brand über mindestens einen Tag Dauer bei mindestens 870 °C wird durch Abschrecken beendet, um ein mit Ca oder Cu übersattigtes Glas herzustellen. Im nachfolgenden Glühbrand bei 870 °C an Luft über beispielsweise einen Tag Dauer werden Präzipitate erzeugt.

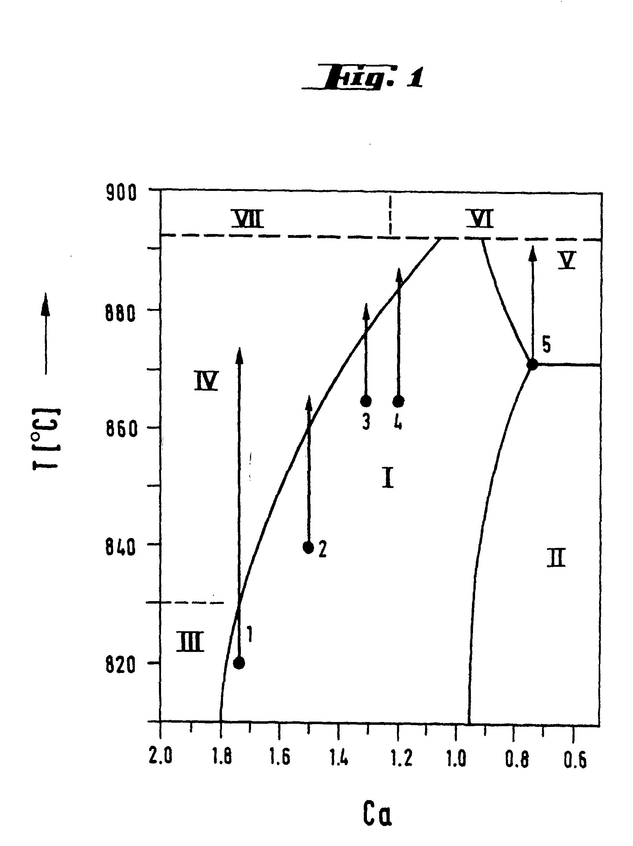

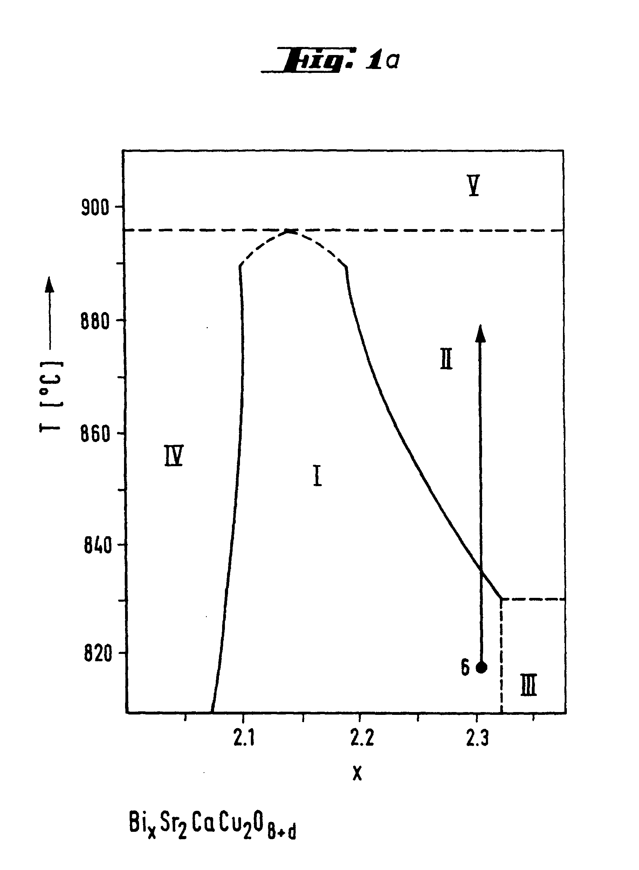

Die Grundlage für die Entwicklung eines Verfahrens zur Erhöhung der Pinning-Eigenschaften keramischer Bi-Sr-Ca-Cu-O Supraleiter ist die Kenntnis der Phasengleichgewichte im System Bi₂O₃-SrO-CaO-CuO, speziell der Ausdehnung des Homogenitätsbereiches der supraleitenden Verbindung Bi₂₊ₓ(Sr,Ca)₃CU₂O_{8+d}(2212-Phase, T_{c} ≤ 94 K) als Funktion der Temperatur (Figur 1).

Es wurde nun gefunden, daß sich durch die Wahl geeigneter Ausgangszusammensetzungen und Glühtemperaturen Sekundärphasenpräzipitate in nahezu phasenreinen Keramiken der 2212-Phase erzeugen lassen, die die Pinning-Eigenschaften dieser Keramiken erhöhen können.

Gegenstand der Erfindung ist daher ein Verfahren zur Erhöhung der Pinning-Kraft von supraleitenden Bi-Sr-Ca-Cu-O Keramik-Formkörpern mit 2212-Phase, das dadurch gekennzeichnet ist, daß man einen Bi-Sr-Ca-Cu-O Keramik-Formkörper herstellt, der die 2212-Phase phasenrein oder nahezu phasenrein aufweist, daß man ihn dann 1 bis 45 Minuten lang unter reinem Sauerstoff oder unter einem Sauerstoff enthaltenden Gas auf eine Temperatur von 825 bis 900 °C erhitzt, die oberhalb der Sintertemperatur liegt, so daß man eine Temperatur erreicht, bei der nicht mehr die reine 2212-Phase vorliegt, sondern man ein Mehrphasen-System erreicht und dabei Sekundärphasen-Präzipitate erzeugt, und daß man ihn nach dem Erhitzen abschreckt.

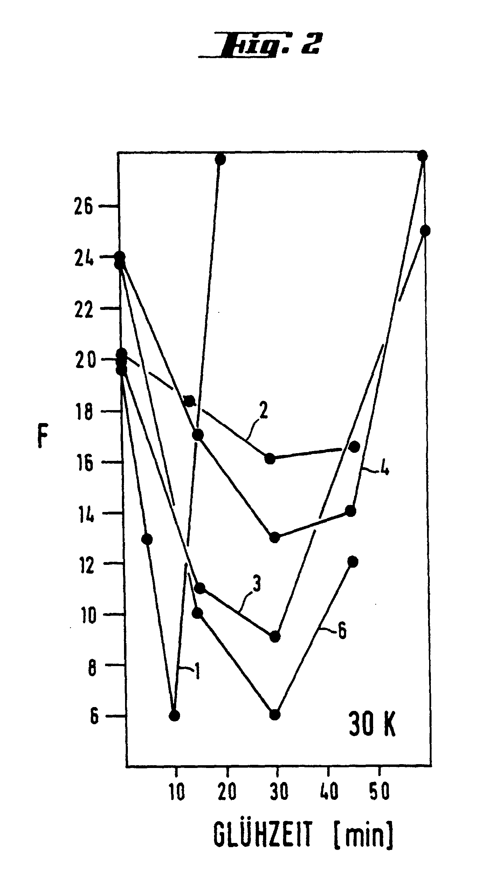

Die phasenreine 2212-Phase in dem System Bi-Sr-Ca-Cu-O ist eingehend in Advanced Materials, 1992, S. 508-511 beschrieben, auf die hier ausdrücklich Bezug genommen wird. Der Bereich, in dem die 2212-Phase thermostabil existiert, ist temperaturabhängig. So läßt sich beispielsweise diese 2212-Phase für eine Temperatur von 820 °C wie folgt definieren: 2,05/0,95 ≥ Sr/Ca ≥ 1,2/1,8; Bi-Gehalt 2,1 bis 2,3; Cu-Gehalt 2. Erfindungsgemäß wird die Pinning-Kraft dieser 2212-Phase dadurch erhöht, indem man Formkörper, die aus dieser Phase bestehen, unter Sauerstoff oder unter einer Sauerstoff enthaltenden Atmosphäre, vorzugsweise Luft, auf eine Temperatur innerhalb des angegebenen Temperaturbereichs erhitzt. Die Glühzeit beträgt dabei 1 bis 45 Minuten. Die Glühtemperatur ist so zu wählen, daß eine Temperatur erreicht wird, bei der nicht mehr die reine 2212-Phase vorliegt, sondern ein Mehrphasen-System erreicht wird, das neben der reinen 2212-Phase noch eine oder mehrere andere Phasen enthält. Auf diese Weise erreicht man die Bildung von Sekundärphasen-Präzipitaten, die für die gewünschte Erhöhung der Pinning-Kraft sorgen. Vorzugsweise arbeitet man unter folgenden Bedingungen: 880 bis 895 °C für ca. 30 Minuten an Luft oder in reinem Sauerstoff bei einem Bi-Gehalt der 2212-Phase von 2,18 und einem Sr/Ca-Verhältnis von 1,1/1,3 bis 1,9/1,1; 885 bis 895 °C für ca. 30 Minuten in reinem Sauerstoff bei einem Bi-gehalt der 2212-Phase von 2,18 und einem Sr/Ca-Verhältnis von 2,2/0,8 bis 2,3/0,7; 870 bis 880 °C für 30 Minuten in Luft bei einem Bi-Gehalt der 2212-Phase von 2,3 und einem Sr/Ca-Verhältnis von 2/1. Die , geschilderten Verhältnisse sollen hier anhand der Figur 1 und der Fig. 1a noch näher erläutert werden (siehe auch die entsprechende Figur 2 in Advanced Materials, . 1992, S. 509). In dieser Figur 1 bezeichnen die Zahlen I bis VII folgende Phasen:
I: reine 2212-Phase;
II: 2212-Phase + Sr₁₄Cu₂₄O₄₁₋ₓ + (Sr,Ca)₃Bi₂O₆ + Raveau Phase;
III: 2212-Phase + Ca₂CuO₃ + γ-Phase;
IV: 2212-Phase + Ca₂CuO₃ + Schmelze;
V: 2212-Phase + (Sr, Ca) CuO₂ + (Sr,Ca)₃Bi₂O₆ + Schmelze;
VI: Schmelze + (Sr,Ca)CuO₂ + Cu₂O + O₂;
VII: Schmelze + Ca₂CuO₃ + Cu₂O + O₂;
An Fig. 1a bezeichnen die Zahlen I bis V folgende Phasen:
I: reine 2212-Phase;
II: 2212-Phase + Schmelze;
III: 2212-Phase + Raveau Phase;
IV: 2212-Phasen + (Sr,Ca)₁₄Cu₂₄O₄₁₋ₓ + Ca₂CuO₃ + (Sr,Ca)₃Bi₂O₆;
V: Schmelze + Raveau Phase + (Sr,Ca)CuO₂.

Die innerhalb der 2212-Phase in Fig. 1 und Fig. 1a eingetragenen Zahlen 1 bis 5 und 6 geben die Zusammensetzung von sechs verschiedenen Chargen innerhalb der 2212-Phase an und die dazugehörigen Pfeile zeigen, auf welche Temperatur die jeweiligen Chargen erhitzt werden. Durch das Erhitzen (Glühen) dieser Chargen wurde ein Bereich angesteuert, in dem neben der reinen 2212-Phase noch weitere Phasen existieren, die die Sekundär-Präzipitate bilden, die wiederum für die Erhöhung der Pinning-Kraft verantwortlich sind.

### Beispiele

Es wurden Chargen unterschiedlicher Zusammensetzung sowohl pulvermetallurgisch als auch nach dem Schmelzguß-Verfahren hergestellt. Die Chargen haben die Zusammensetzungen:
1) Bi_{2,18}Sr_{1,25}Ca_{1,75}Cu₂Oₓ
2) Bi_{2,18}Sr_{1,5}Ca_{1,5}Cu₂Ox
3) Bi_{2,18}Sr_{1,7}Ca_{1,3}Cu₂Ox
4) Bi_{2,18}Sr_{1,8}Ca_{1,2}Cu₂Oₓ
5) Bi_{2,18}Sr_{2,25}Ca_{0,75}Cu₂Oₓ
6) Bi_{2,3}Sr₂CaCu₂Oₓ

Die Chargen 1, 2, 5 und 6 wurden pulvermetallurgisch hergestellt. Die Chargen wurden bei 750 °C 36 Stunden und darauf bei 790 °C 24 Stunden lang kalziniert. Vor dem Pressen der Grünkörper wurden die Pulver im Porzellanmörser homogenisiert. Die Grünkörper wurden bei 820 °C 60 Stunden (Charge 1 und 6), bei 840 ° C 60 Stunden (Charge 2) und bei 870 °C 60 Stunden lang gesintert.

Die Chargen 3 und 4 wurden nach dem Schmelzgußverfahren hergestellt. Anschließend wurden die Schmelzgußkörper nochmals bei 865 °C 60 Stunden lang gesintert.

Die sechs Chargen sind nahezu phasenrein. Die Sinterkörper der Charge 1 enthalten Ca₂CuO₃ als Sekundärphase (ca. 1 Vol.-%). Die Sinterkörper der Chargen 2, 5 und 6 enthalten keine Sekundärphasen. Die Sinterkörper der Chargen 3 und 4 enthalten CuO als Sekundärphase (ca. 5 Vol.-%). Die chemische Zusammensetzung der 2212-Phase wurde mit Hilfe der Elektronenstrahlmikroanalytik bestimmt. Es ergaben sich dabei folgende chemische Zusammensetzungen dieser Phase:
- Charge 1:: Bi_{2,18}Sr_{1,25-1,2}Ca_{1,75-1,8}Cu₂Oₓ
- Charge 2:: Bi_{2,18}Sr_{1,5-1,55}Ca_{1,5-1,45}Cu₂Oₓ
- Charge 3:: Bi_{2,18}Sr_{1,7-1,75}Ca_{1,3-1,25}Cu₂Oₓ
- Charge 4:: Bi_{2,18}Sr_{1,8}Ca_{1,2}Cu₂Oₓ
- Charge 5:: Bi_{2,18}Sr_{2,27}Ca_{0,73}Cu₂Oₓ
- Charge 6:: Bi_{2,28}Sr₂CaCu₂Oₓ

Die Sinterkörper der Charge 1 wurden daraufhin bei 875 °C 5, 10, 20 und 30 Minuten lang geglüht. Die Sinterkörper der Charge 2 wurden bei 865 °C 15, 30, 45 und 60 Minuten lang geglüht. Die Sinterkörper der Charge 3 wurden bei 880 °C 5, 15, 30 und 60 Minuten lang geglüht. Die Sinterkörper der Charge 4 wurden bei 887 °C 15, 30, 45 und 60 Minuten lang geglüht. Die Sinterkörper der Charge 5 wurden bei 885 °C und 895 °C 15, 30, 45 und 60 Minuten und bei 850 °C 24, 48 und 70 Stunden lang geglüht. Die Sinterkörper der Charge 6 wurden bei 880 °C 15, 30, 45 und 60 Minuten lang geglüht. Die einzelnen Proben der jeweiligen Chargen zeigten keine Veränderung ihrer Geometrie.

Die Glühungen erfolgen an Luft. Die Proben wurden nach der Glühung in Luft auf einer Kupferplatte (ca. 10 mm stark) abgeschreckt. Die Abschreckrate beträgt ca. 100 K pro Sekunde für das Temperaturintervall von Glühtemperatur bis 600 °C und ca. 10 K pro Sekunde für das Temperaturintervall von 600 °C bis Raumtemperatur.

Die Gefüge der Proben wurden mit Hilfe eines Elektronenmikroskops und des Auflichtmikroskops im polarisierten Licht untersucht. Dabei zeigte sich überraschend, daß sich bereits nach 15 Minuten in den Proben Sekundärphasen-Präzipitate gebildet haben. Elektronenstrahlmikroanalysen der Sekundärphasen-Präzipitate in den Proben der Charge 3 ergaben Ca₂CuO₃ in Form von schwarzen linsenförmigen Kristallen. Ebenso konnten (Sr,Ca)₁₄Cu₂₄O₄₁₋ₓ, (Sr,Ca) CuO₂ und (Sr,Ca)₃Bi₂O₆ bei den Proben der Charge 5, die Schmelze bei den Proben der Charge 6 sowie die unterschiedlichen chemischen Zusammensetzungen der 2212-Phase vor und nach den jeweiligen Glühungen mit Hilfe der Elektronenstrahlmikroanalytik identifiziert werden.

Bei den Proben der Charge 5, die bei 850 °C 24, 48 und 70 Stunden lang geglüht wurden, konnten entsprechende Beobachtungen erst nach 70 Stunden Glühzeit gemacht werden. Mit zunehmender Glühzeit nimmt der Anteil sowie die maximale Größe der Ausscheidungen zu.

Die Qualität der Pinning-Zentren in den so behandelten Proben wurde auf folgende Weise bestimmt:

Bei konstanter Temperatur (T < T_{c}) wird die supraleitende Probe einem äußeren Magnetfeld ausgesetzt um einen Suprastrom zu induzieren. Gemessen wird nun die Magnetisierung der Probe bei Erhöhung des äußeren Magnetfeldes, wobei das Vorzeichen des äußeren Magnetfeldes zweimal gewechselt wird. Die in der Probe vorhandenen Pinning-Zentren sind verantwortlich dafür, daß trotz entgegengesetztem äußeren Magnetfeld im Inneren der Probe noch magnetischer Fluß in der ursprünglichen Richtung (vor der Umpolung des Magnetfeldes) verbleibt und die Magnetisierungskurve eine ausgeprägte Hysterese zeigt. Die Differenzierung der Magnetisierung ΔM ist proportional der Pinning-Kraft, die ein Ensemble von Pinning-Zentren der Bewegung der Flußschläuche entgegensetzt. Ein vergleichbares Maß für die Pinning-Kraft einer Probe ist daher auch der Quotient F = [ΔM _{300 Gauss}]/[ΔM_{20000 Gauss}]. Die Verwendung dieses Quotienten ist auch deswegen von Vorteil, weil probenspezifische Einflußgrößen (Dichte, Geometrie) dabei normiert werden.

Für F gilt:
- F = 1:: ideales Pinning, kein Einfluß des äußeren Magnetfeldes auf den Supraleiter bei 20000 Gauss.
- F → ∞:: kein Pinning.

Die Messungen der Hysterese der Magnetisierung der Proben der Chargen 1, 2, 3, 4 und 6 bei 5 Kelvin und 30 Kelvin zeigen, daß die Magnetisierung der einzelnen Proben jeder Charge eine Funktion der Glühzeit der letzten Glühung ist.

In Figur 2 ist der Faktor F (Quotient aus der Magnetisierung einer Probe bei 300 Gauss und der Magnetisierung dieser Probe bei 20.000 Gauss) gegen die Glühzeit der letzten Glühung jeder Probe bei der jeweiligen Glühtemperatur aufgetragen. Die Messungen erfolgten bei 30 K. Die Probenserien zeigen jeweils ein Minimum des Faktors F bei 5 bzw. 30 Minuten. 1 bedeutet Proben der Charge 1, 2 bedeutet Proben der Charge 2, 3 bedeutet Proben der Charge 3,4 bedeutet Proben der Charge 4 und 6 bedeutet Proben der Charge 6.

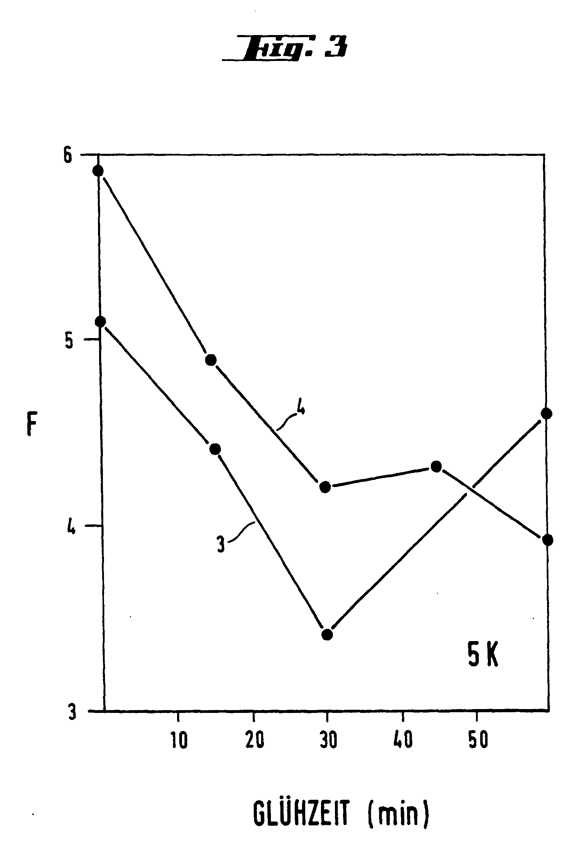

In Figur 3 ist der Faktor F (Quotient aus der Magnetisierung einer Probe bei 300 Gauss und der Magnetisierung dieser Probe bei 20.000 Gauss) gegen die Glühzeit der letzten Glühung jeder Probe bei der jeweiligen Glühtemperatur aufgetragen. Die Messungen erfolgten bei 5 K. Die Probenserien zeigen kein bzw. ein weit geringer ausgeprägtes Minimum des Faktors F. 3 bedeutet Proben der Charge 3 und 4 bedeutet Proben der Charge 4.

Figur 2 zeigt für die Proben der Chargen 1,2, 3, 4 und 6 ein Minimum des Faktors F bei 5 bis 30 Minuten. Das Auftreten des jeweiligen Minimums des Faktors F bei unterschiedlichen Glühzeiten ist vermutlich darauf zurückzuführen, daß aufgrund der unterschiedlichen Ca-Gehalte der 2212-Phase der vier Chargen die Umwandlungstemperatur und die zu bildenden Volumenanteile an Ca₂CuO₃ und Schmelze entsprechend Figur 1 sehr unterschiedlich sind, so daß sich die 2212-Phase in den Proben der Charge 1 bei 875 °C deutlich schneller zersetzt und hier deutlich mehr Volumenanteile Ca₂CuO₃ und Schmelze gebildet wird als bei den Proben der Chargen 3 und 4.

Aus der Magnetisierung der Proben läßt sich die Stromtragfähigkeit J_{c} der Proben errechnen. J_{c} der Proben im Magnetischen Nullfeld beträgt 10³ A/cm² (30 K) bzw. 10⁴ A/cm² (5 K), bei 300 Gauss 10² A/cm² (30 K) bzw. 10⁴ A/cm² (5 K) und bei 20.000 Gauss 10¹ A/cm² (30 K) bzw. 10³ A/cm² (5 K).

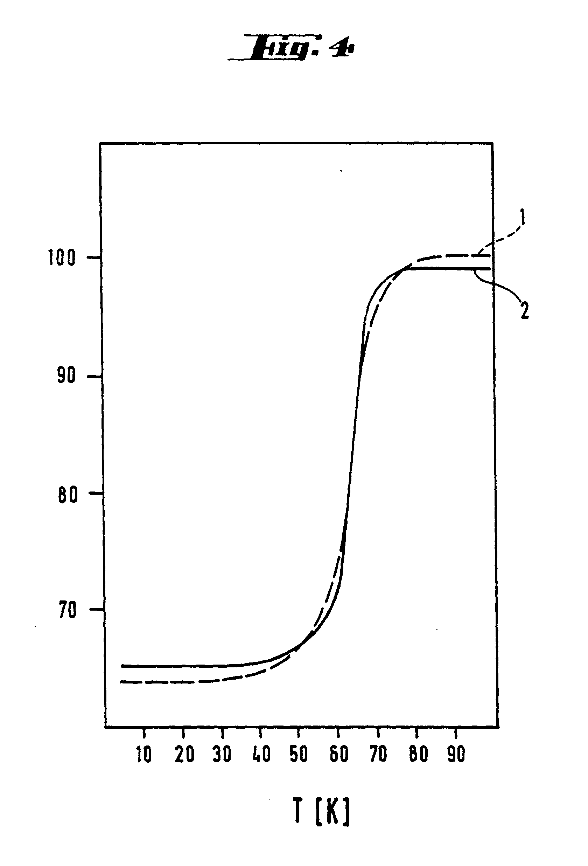

Figur 4 zeigt die Sprungtemperatur, bestimmt mit Hilfe der AC Suszeptibilitätsmessung, der unbehandelten (1) und der bei 887 °C 30 Minuten lang geglühten (2) Probe der Charge 4. Die Sprungtemperatur beider Proben ist gleich, allerdings mit ca. 70 K sehr gering. Die Glühung bei 887 °C hat somit keinen Einfluß auf die supraleitenden Eigenschaften der 2212-Phase.

Die Tatsache, daß die Glühung der Proben die Sprungtemperatur der Proben nicht erhöht hat und daß die Verringerung des Faktors F bei 5 K nicht bzw. weit weniger ausgeprägt ist als bei 30 K, zeigt, daß die Bildung der Ausscheidungen in den Proben eine Erhöhung der Pinning-Kraft der Proben verursacht, da erwartungsgemäß das erhöhte Pinning der Proben erst bei Temperaturen oberhalb 5 K zu registrieren ist. Durch eine Bildung von Sekundärphasen-Präzipitaten können die Proben somit bei gleichem äußeren Magnetfeld einen höheren Strom tragen.

Überraschend und unerwartet ist, daß diese Sekundärphasen-Präzipitate sich bereits nach Glühzeiten von weniger als 60 min bilden und daß die damit kombinierte Erhöhung der Pinning-Kraft ebenfalls innerhalb dieser kurzen Glühzeit erreicht werden kann.

Zu den erfindungsgemäßen Beispielen gehören die folgenden Proben:
- Charge 1: Glühung 5, 10 und 20 Minuten,
- Charge 2: Glühung 15, 30 und 45 Minuten,
- Charge 3: Glühung 5, 15 und 30 Minuten,
- Charge 4: Glühung 15, 30 und 45 Minuten sowie
- Charge 6: Glühung 15, 30 und 45 Minuten.

Die charges 5 ist als Vergleichsbeispiel anzusehen.

## Patentansprüche

1. Verfahren zur Erhöhung der Pinning-Kraft von supraleitenden Bi-Sr-Ca-Cu-O Keramik-Formkörpern mit 2212-Phase, **dadurch gekennzeichnet, daß** man einen Bi-Sr-Ca-Cu-O Keramik-Formkörper herstellt, der die 2212-Phase phasenrein oder nahezu phasenrein aufweist, daß man ihn dann 1 bis 45 Minuten lang unter reinem Sauerstoff oder unter einem Sauerstoff enthaltenden Gas auf eine Temperatur von 825 bis 900 °C erhitzt, die oberhalb der Sintertemperatur liegt, so daß man eine Temperatur erreicht, bei der nicht mehr die reine 2212-Phase vorliegt, sondern man ein Mehrphasen-System erreicht und dabei Sekundärphasen-Präzipitate erzeugt, und daß man ihn nach dem Erhitzen abschreckt.

2. Verfahren nach Anspruch 1, **dadurch gekennzeichnet, daß** man bei 880 ° bis 895 °C für 30 Minuten an Luft oder in reinem Sauerstoff erhitzt, wenn der Bi-Gehalt der 2212-Phase 2,18 beträgt und das Sr/Ca Verhältnis Werte von 1,1/1,3 bis 1,9/1,1 aufweist.

3. Verfahren nach Anspruch 1, **dadurch gekennzeichnet, daß** man bei 885 ° bis 895 °C für 30 Minuten in reinem Sauerstoff erhitzt, wenn der Bi-Gehalt der 2212-Phase 2,18 beträgt und das Sr/Ca Verhältnis Werte von 2,2/0,8 bis 2,3/0,7 aufweist.

4. Verfahren nach Anspruch 1, **dadurch gekennzeichnet, daß** man bei 870 ° bis 880 °C für 30 Minuten in Luft erhitzt, wenn der Bi-Gehalt der 2212-Phase 2,3 beträgt und das Sr/Ca Verhältnis 2/1 ist.

## Claims

1. A process for increasing the pinning force of super-conducting Bi-Sr-Ca-Cu-O ceramic moldings having a 2212 phase, which comprises producing a Bi-Sr-Ca-Cu-O ceramic molding which comprises the 2212 phase as a pure phase or as a virtually pure phase, then heating said ceramic molding under pure oxygen or an oxygen-containing gas for from 1 to 45 minutes to a temperature of from 825 to 900°C, which is above the sintering temperature, so that a temperature is reached at which the pure 2212 phase is no longer present but a multiphase system is obtained, and generating secondary-phase precipitates in the process, and rapidly cooling said molding after heating.

2. The process as claimed in claim 1 which comprises heating at from 880 to 895°C for 30 minutes in air or in pure oxygen, if the Bi content of the 2212 phase is 2.18 and the Sr/Ca ratio has values of from 1.1/1.3 to 1.9/1.1.

3. The process as claimed in claim 1 which comprises heating at from 885 to 895°C for 30 minutes in pure oxygen, if the Bi content of the 2212 phase is 2.18 and the Sr/Ca ratio has values of from 2.2/0.8 to 2.3/0.7.

4. The process as claimed in claim 1 which comprises heating at from 870 to 880°C for 30 minutes in air, if the Bi content of the 2212 phase is 2.3 and the Sr/Ca ratio is 2/1.

## Revendications

1. Procédé pour l'augmentation de la force de pinning de corps moulés en céramique supraconductrice Bi-Sr-Ca-Cu-O ayant une phase 2212, **caractérisé en ce que**, l'on prépare un corps moulé en céramique Bi-Sr-Ca-Cu-O qui présente la phase 2212 pure ou presque pure, **en ce qu'**on le chauffe ensuite pendant de 1 à 45 minutes sous oxygène pur, ou sous un gaz contenant de l'oxygène, à une température de 825 à 900°C, qui est située au-dessus de la température de frittage, de manière à atteindre une température à laquelle la phase pure 2212 n'existe plus, mais où on atteint un système multiphasé et on produit alors des précipités de phases secondaires, et **en ce qu'**on le refroidit rapidement après l'avoir chauffé.

2. Procédé selon ta revendication 1, **caractérisé en ce que**, l'on chauffe de 880° jusqu'à 895°C pendant 30 minutes à l'air ou dans l'oxygène pur, lorsque le titre en bismuth de la phase 2212 se monte à 2,18 et le rapport Sr/Ca atteint des valeurs de 1,1 /1,3 à 1,9/1,1.

3. Procédé selon la revendicaiton 1, **caractérisé en ce que** l'on chauffe de 885° jusqu'à 895°C pendant 30 minutes dans l'oxygène pur, lorsque le titre en bismuth de la phase 2212 se monte à 2,18 et te rapport Sr/Ca atteint des valeurs de 2,2/0,8 à 2,3/0,7.

4. Procédé selon la revendication 1, **caractérisé en ce que**, l'on chauffe de 870°jusqu'à 880°C pendant 30 minutes à l'air, lorsque le titre en bismuth de la phase 2212 se monte à 2,3 et le rapport Sr/Ca est de 2/1.
